# EUROPEAN PATENT APPLICATION

(11) **EP 3 316 490 A1**
(43) Date of publication of application: **02.05.2018**
(21) Application number: 17198654.0
(22) Date of filing: 26.10.2017
(51) Int. Cl.: H04B 1/525, H04B 1/48

(54) **TX CANCELLATION SYSTEM BY SOURCE INJECTION**

(30) Priority: 28.10.2016 US 201662414510 P; 31.10.2016 US 201662415254 P
(71) Applicant: ACCO, 78430 Louveciennes (FR)
(72) Inventor: SETTAF, Zakaria, 78000 Versailles (FR); CAM, Hervé, 78720 Cernay-la-ville (FR); BLAMON, Guillaume, 92400 COURBEVOIE (FR); HUIN, Francis, 76620 LE HAVRE (FR)
(74) Representative: Lavoix

(57) **Abstract**

Cancellation of a leaked transmission signal received together with a received signal is cancelled at a receiver amplifier in a system made up of the receiver amplifier, a power amplifier, and a duplexer that couples both to an antenna. A portion of the amplified transmission signal from the power amplifier is split off prior to the duplexer. That portion is controllably applied to the receiver amplifier. A feedback loop monitors the amplified output of the receiver amplifier and varies the gain and phase of the portion of the amplified transmission signal in order to minimize the amount of transmission signal in the amplified output of the receiver amplifier.

## Description

### BACKGROUND

### Field of Invention

The present invention relates generally to RF circuits and more particularly to duplexers that connect both a receiver and a transmitter to a common antenna.

### Related Art

Modern telephones use a full duplex transmission mode, that is, the telephone is able to both transmit and receive at the same time. To do this, the telephone employs different channels, that is, frequency bands that do not overlap. However, it is desirable to mass produce mobile telephones that operate in more than just two channels. Different geographic zones and/or countries set different standards, and even within a region having additional bands provides greater capacity. Therefore, mobile telephones are designed with the ability to operate over many more than two frequency bands. These frequency bands differ from each other, not only by their center frequencies, but also by the range of frequencies, i.e., the bandwidth, each channel occupies.

Duplexers are specific components which are used to separate channels where a single antenna is employed, such as in a transceiver. A common type of duplexer is basically two side-by-side filters with a common antenna point and two specific access points, one for transmission (Tx) and one for reception (Rx). Each filter is optimized to the center frequency and bandwidth of the band the filter serves. Thus, each duplexer is optimized for two specific bands, one for Tx and one for Rx, and the telephone must use as many duplexers as necessary to account for the number of bands that the telephone is meant to cover. An 8-channel telephone would therefore need four duplexers.

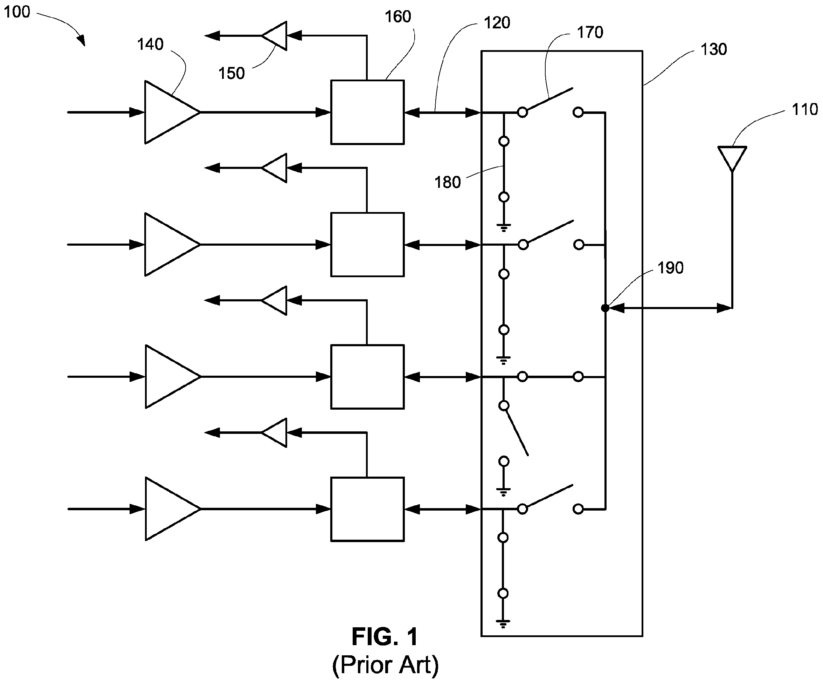

FIG. 1 illustrates a prior art transceiver including an RF circuit 100 coupled to an antenna 110. The circuit 100 comprises a number of transit paths 120 and an antenna switch 130 that couples the antenna 110 to the several transit paths 120. Each transit path 120 includes a power amplifier 140 and a receiver amplifier 150 alternately joined to the antenna switch 130 by a duplexer 160. Within the antenna switch 130, each transit path 120 is switchably coupled to the antenna 110 by a series switch 170 and optionally also switchably coupled to ground by a parallel switch 180.

In macroscopic terms, the duplexer 160 isolates Tx and Rx channels and filters the respective RF signals. Surface Acoustic Wave (SAW) duplexers separate the Tx and Rx channels by alternatingly filtering out the unwanted signals. For example, in the Tx mode, the unwanted signals that are removed include the Rx signal as well as harmonics and various spurious signals produced by internal clocks. In the Rx mode, filters attenuate unwanted out-of-band signals coming from the antenna 110 and also attenuate the leakage from the Tx channel.

The major issue of the duplexer 160 is that a strong Tx signal may leak into the receiver amplifier 150.

### SUMMARY

An exemplary tunable duplexer of the present invention comprises a first coupler and a second coupler, identical to the first, in combination with two phase shifters. Each phase shifter induces a phase shift of 90° to all received signals. Each coupler has four ports where a signal, either received from an antenna or being transmitted by an antenna, received at a first port is divided between the other three ports. The signal is divided such that a first portion of the signal is directed to a second port, and a second portion of the signal, being the remainder of the initial signal, is split between the third and fourth ports. Moreover, the signal reaching the third port includes a 90° phase shift, while the signal reaching the second and fourth ports are not phase shifted and therefore maintain the initial phase of the received signal.

While both couplers are identical, in operation the first portion of the signal that is directed to the second port by the first coupler is negligible, while this portion of the signal received at the first port of the second coupler is adjustable to cancel an out-of-phase signal received at the second port of the second coupler. For each channel that the duplexer servers, the first and second couplers include a number of switches to vary how much of the signal received at the first port of the second coupler is directed to cancelling the out-of-phase signal at the second port of the second coupler, which is frequency dependent.

In embodiments of the exemplary duplexer, a first phase shifter of the two phase shifters is coupled between the third port of the first coupler and a first port of the second coupler. A second phase shifter is coupled between the fourth port of the first coupler and the same port of the second coupler. Additionally, another port of the second coupler (the third port if one employs the port numbering of the first coupler) is coupled to the second port of the first coupler. By correctly orienting the directions of phase rotation of the phase shifters, the initial signal is split and split again, with two signal paths through the circuit each bringing a fully out-of-phase signal to the second port of the second coupler. Another signal path brings a portion of the non-phase shifted signal also to the second port of the second coupler, and all three signals cancel at this point. The second port of the second coupler is the input to the receiver amplifier where the first port of the first coupler receives the output of the power amplifier.

In various embodiments, each coupler of the exemplary duplexer includes two parallel lines, one joining the first port with the third port, the other joining the second port with the fourth port. The two parallel lines each include an inductor and a capacitor in series, collectively known as an LC circuit. A node on the first parallel line between the LC circuit and the third port is coupled by another capacitor to a node on the second parallel line disposed between the LC circuit and the fourth port. Yet another capacitor couples the node between the LC circuit and the third port on the first parallel line to ground. Similarly, a node on the first parallel line between the LC circuit and the first port is coupled by still another capacitor to a node on the second parallel line between the LC circuit and the second port; a still further capacitor couples the node on the first parallel line between the LC circuit and the first port to ground, and yet still another capacitor couples the node on the second parallel line between the LC circuit and the second port to ground. Any of these capacitors of the exemplary duplexer can be switchable to vary the capacitance at the given point in the circuit between a number of fixed values in order to change channels.

In various embodiments, a phase shifter can comprise inductors in series, wherein each node between adjacent inductors is coupled to ground by a capacitor. Likewise, a phase shifter can comprise capacitors in series, wherein each node between adjacent capacitors is coupled to ground by an inductor. These two alternatives can induce 90° phase shifts, one forward by 90° the other back by 90°.

Transceivers of the present invention comprise the exemplary duplexer having 8 ports, four ports on each of two couplers, where one port of one coupler is coupled to a power amplifier and one port of the other coupler is coupled to a receiver amplifier. Two additional coupler ports can be coupled to an antenna, one port from each coupler, in further embodiments, such that the antenna is coupled to a node between the fourth port of the first coupler and the second phase shifter. In various embodiments the node at which the antenna connects comprises an electrical connector. In various embodiments, the transceiver is implemented on a CMOS chip.

An exemplary method of the present invention is directed to operating a duplexer. The method comprises receiving a signal in a first port of the duplexer and splitting the signal into a first portion and a second portion. A component of the first portion of the signal is phase shifted by 180°. The second portion is split again into two components, and a first component of the second portion of the signal is also phase shifted by 180°. The two phase-shifted components are then combined with the second component of the second portion of the signal, which is not phase shifted, to mutually cancel all three at another port of the duplexer. In various embodiments, the signal is a transmitted signal and the cancellation occurs at the port coupled to a receiver amplifier. In some of these embodiments the method further includes generating the transmission signal with a power amplifier. In various other embodiments, the signal is a received signal received from an antenna and the cancellation occurs at the port coupled to the power amplifier.

In further embodiments, the exemplary method additionally comprises a step of switching an operating channel of the duplexer. This step can be achieved, for example, by controlling switch settings within the duplexer. In various embodiments, the switches can vary electrical properties such as capacitance, resistance, and inductance at points within the duplexer to tune the duplexer to the different operating channels. For instance, multiple capacitors switchably arranged in parallel can be employed to vary the capacitance at a point in the circuit, according to which switches are open and which are closed.

An exemplary circuit of the present invention comprises a power amplifier, a receiver amplifier, and a duplexer connected to the power amplifier and to the receiver amplifier and configured to connect to an antenna. In some embodiments the circuit also comprises the antenna. The power amplifier includes an input for receiving an input signal and has an output for a transmission signal that is the input signal amplified. The receiver amplifier has an output for an amplified receiver signal. The duplexer is connected to the power amplifier to receive the transmission signal therefrom, and provides an antenna signal from the antenna to an input of the receiver amplifier, but can leak some of that transmission signal to the receiver amplifier along with the signal from the antenna. The exemplary circuit further comprises a directional coupler disposed between the power amplifier and the duplexer and configured to pass a majority of the transmission signal to the duplexer and further configured to direct a balance of the transmission signal to a feedback loop. The feedback loop of the exemplary embodiment is configured to adjust a gain and a phase of the balance of the transmission signal to produce a phase and gain adjusted signal, the feedback loop being further configured to apply the phase and gain adjusted signal to the receiver amplifier.

In various embodiments the feedback loop can include a gain control circuit and a phase control circuit arranged in series, wherein one of the gain and phase control circuits receives the balance of the transmission signal and the other of the gain and phase control circuits applies the phase and gain adjusted signal to the receiver amplifier. These circuits can be placed in either order and in some embodiments the functions of both are combined into a single circuit. In some of these embodiments the feedback loop further includes a Tx cancellation circuit configured to control the gain and phase control circuits based on the amplified receiver signal. In some of these embodiments the other of the gain and phase control circuits applies the phase and gain adjusted signal to a source of the receiver amplifier.

In various embodiments of the exemplary circuit the receiver amplifier is a differential amplifier including a pair of transistors, and in some of these embodiments the receiver amplifier includes a balun bridging the sources of the pair of transistors and the phase and gain adjusted signal is applied to the receiver amplifier through the balun. In still other embodiments of the exemplary circuit the duplexer comprises a first coupler having four ports, a second coupler identical to the first coupler, a first phase shifter coupled between a first port of the first coupler and a first port of the second coupler, and a second phase shifter coupled between a second port of the first coupler and another port of the second coupler.

An exemplary method of the invention is directed to cancelling a leaked transmission signal at a receiver amplifier. The exemplary method comprises both transmitting and receiving while transmitting. Transmitting is performed by amplifying a first signal to produce a first amplified signal, such as with a power amplifier, splitting the first amplified signal into a first portion comprising a majority of the first amplified signal and a second portion comprising a balance of the first amplified signal, and transmitting the first portion to a duplexer coupled to an antenna, wherein a segment of the first portion becomes the leaked transmission signal. The steps of splitting the signal and transmitting the first portion can be performed, for example, by a directional coupler.

The receiving while transmitting is performed by receiving from the antenna, through the duplexer, at the receiver amplifier a second signal, receiving through the duplexer at the receiver amplifier the leaked transmission signal, and applying the second portion of the first amplified signal to the receiver amplifier to cancel the leaked transmission signal. This last step can be performed by a feedback loop, for instance. In various embodiments applying the second portion of the first amplified signal to the receiver amplifier includes applying the second portion to a source of the receiver amplifier. Applying the second portion of the first amplified signal to the receiver amplifier can also include, in some embodiments, adjusting a gain and a phase of the second portion. In some of these embodiments, adjusting the gain and phase of the second portion includes monitoring an amplified output of the receiver amplifier. In various embodiments the feedback loop comprises a Tx cancellation circuit that monitors the amplified output of the receiver amplifier and varies gain and phase control circuits, digitally in some instances, to continually match the gain and phase of the second portion to that of the leaked transmission signal.

### BRIEF DESCRIPTION OF THE DRAWINGS

FIG. 1 is a schematic representation of RF transceiver according to the prior art.
FIG. 2 is a schematic representation of an RF transceiver including a duplexer according to various embodiments of the present invention.
FIG. 3 is a schematic representation of the functionality of a tunable coupler, according to various embodiments of the present invention.
FIGs. 4-6 are successive representations of the flow of the Tx signal through a duplexer according to various embodiments of the present invention.
FIG. 7 is a schematic representation of a circuit for implementing a coupler according to various embodiments of the present invention.
FIGs. 8 and 9 are schematic representations of two circuits for implementing phase shifters according to various embodiments of the present invention.
FIG. 10 is a flowchart representation of a method for operating a duplexer according to various embodiments of the present invention.
FIG. 11 is a schematic representation of a circuit according to various embodiments of the present invention.
FIG. 12 is a schematic representation of a low noise amplifier according to various embodiments of the present invention.

### DETAILED DESCRIPTION

The present invention provides tunable duplexers, RF transceivers that include a tunable duplexer, and methods of operating RF transceivers. The tunable duplexer of the present invention simplifies the overall architecture of the RF transceiver circuit, allowing for multi-channel switching by simply reconfiguring the duplexer. The tunable duplexer presented herein isolates the Tx and Rx channels without itself performing any signal filtering; filtering to remove other unwanted signals can be performed between the duplexer and the receiver amplifier, for example. The present invention reduces the demands on such filtering.

Duplexers of the present invention employ a pair of couplers and a pair of phase shifters, where each coupler includes four ports. In use, a power amplifier 140 serves as the input to one port, a receiver amplifier 150 is coupled to another port, two ports on each coupler connect to the other coupler via the phase shifters, and the remaining port on each coupler connects to an antenna. A coupler, as used herein, provides the functionality that a signal injected into any port is split between at least two of the other three ports, with one port of the other three ports outputting a signal that is phase shifted by 90°. Couplers having this functionality are sometimes known in the art as hybrid 3dB couplers.

In various embodiments of the duplexer, an initial Tx signal received at the initial port is split multiple times and traverses two electrical paths through the duplexer that ultimately converge at the receiver amplifier 150, both of these signals being 180° out of phase with the initial Tx signal, and the two add constructively. Additionally, another part of the initial Tx signal, obtained through the same signal splitting process but traversing a third electrical path, is also added to the two out-of-phase signals at the receiver amplifier 150. For a given frequency range, the duplexer is configured to add an amount of this third signal sufficient to cancel the sum of the two out-of-phase signals.

It is noted that this process of cancelling the Tx at the receiver amplifier does not attenuate the Rx signal. The Rx signal can be similarly cancelled on the Tx line without attenuating the Tx signal, as the duplexer works the same in both directions. Tuning, or switching between channels, can be achieved by varying electrical components, such as capacitors, at select points within the duplexer circuit.

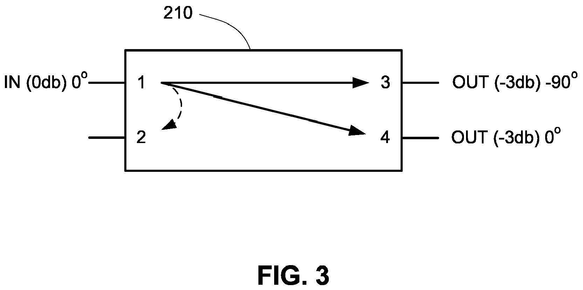

FIG. 2 schematically illustrates an exemplary transceiver 200 including a duplexer 205 according to various embodiments of the present invention. The duplexer 205 can be said to be a SAW-less duplexer in as much as it is not a SAW duplexer. The duplexer 205 comprises two couplers 210 and 220, and two phase shifters 230 and 240. The phase shifters 230, 240 each shift the phase of a received signal by 90°, where one shifts a received signal by 90° and the other shifts a received signal by -90°. Each phase shifter 230, 240 operates the same for signals traveling in either direction such that if a signal propagating in one direction is shifter by -90°, another signal propagating in the opposite direction will also be shifted by -90°.

The duplexer 205 is shown in FIG. 2 coupled to a power amplifier 140, a receiver amplifier 150, and an antenna 110 by transformer 250. For simplicity, some components of the transceiver 200 have been omitted for clarity. For example, various embodiments can include a filter (not shown) between the power amplifier 140 and the duplexer 205 as well as filtering on the side of the receiver amplifier 150 (not shown). Filtering at the receiver amplifier 150 can optionally be disposed within the receiver amplifier 150 or placed after the receiver amplifier 150. It is noted that transceiver 200 can operate in a differential mode where the power amplifier 140 produces a differential output and the receiver amplifier 150 receives a differential input. In these embodiments, a balun is disposed between the power amplifier 140 and the duplexer 205, and another balun is disposed between the duplexer 205 and the receiver amplifier 150.

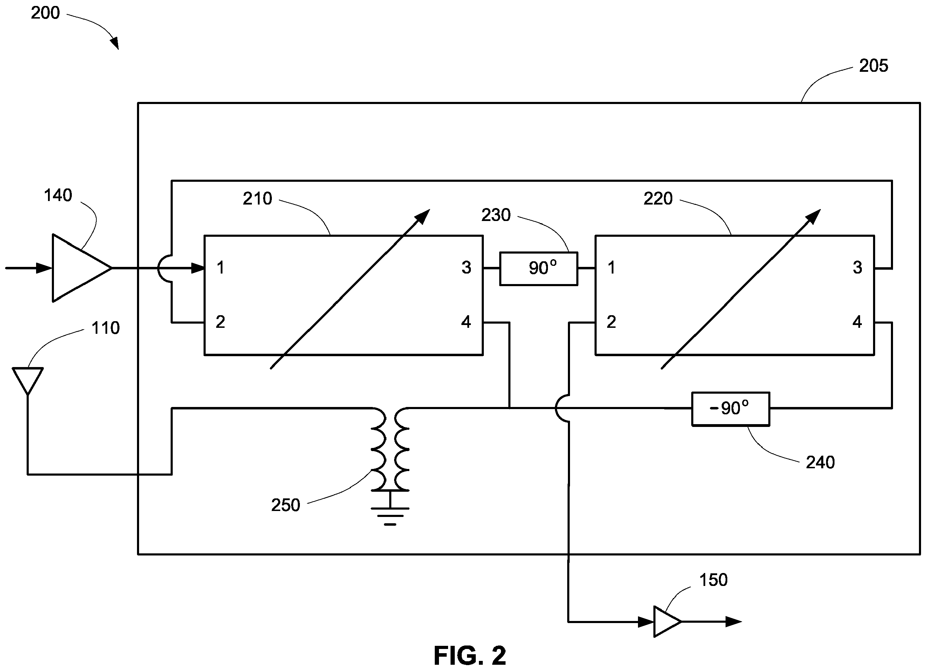

FIG. 3 schematically illustrates the functionality of each of the tunable couplers 210, 220. Each coupler 210, 220 is configured to receive an input signal at a port (1) and to split the input signal into a portion that goes to port (2) and a remainder which is further split into two signals directed to ports (3) and (4). More particularly, one of the two output signals of ports (3) and (4) is out of phase by 90°, and in the illustrated embodiment, the phase of the output signal at port (3) is shifted by -90° relative to the phase of the output signal at port (4) which is not shifted relative to the phase of the input signal at port (1). In various embodiments, the portion of the signal split between ports (3) and (4) is split equally between the two, though this is not a requirement, and in some instances an unequal split can be beneficial.

It will be appreciated that the couplers 210, 220 operate the same for all four ports, such that, for example, a signal received by port (4) will be split between ports (1) and (2) with one resulting signal being phase shifted and the other not. In the duplexer 205, while the coupler 210 is configured such that it can receive an input signal at a port (1) and split the input signal into a portion that goes to port (2), it is configured such that ports (1) and (2) are completely isolated in the frequency range of the Tx signal and essentially all of the input Tx signal is split between ports (3) and (4). On the other hand, coupler 220 does not completely isolate ports (1) and (2) for the same frequency band, as described further below.

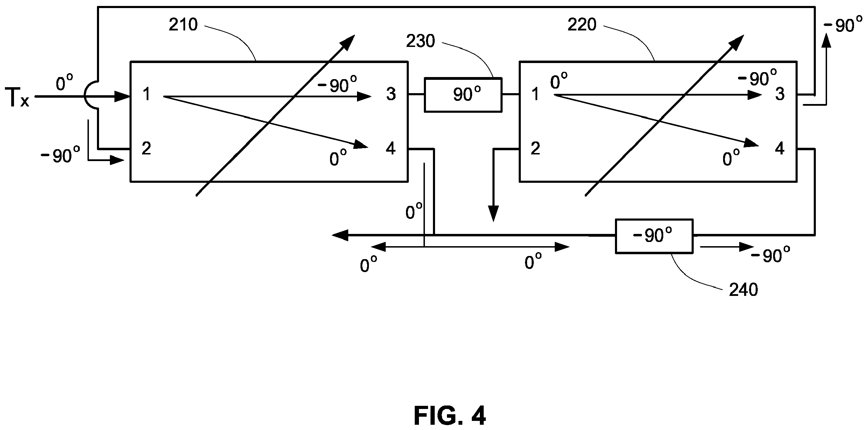

FIG. 4 shows the initial paths of a Tx signal through duplexer 205. It can be seen that the Tx signal received from power amplifier 140 is first received into port (1) of coupler 210 and split into two signals, where the signal output at port (4) is not phase shifted. The output of port (4) of coupler 210 splits at a node between antenna 110 (not shown) and phase shifter 240 into two signals propagating in opposite directions, one to antenna 110 and one to phase shifter 240 which is shifted to -90° and received at port (4) of coupler 220. The signal output at port (3) of coupler 210 is phase shifted by -90° by the coupler 210 and received by the phase shifter 230 which shifts the phase back by 90°, and therefore a non-phase shifted signal is received at port (1) of coupler 220.

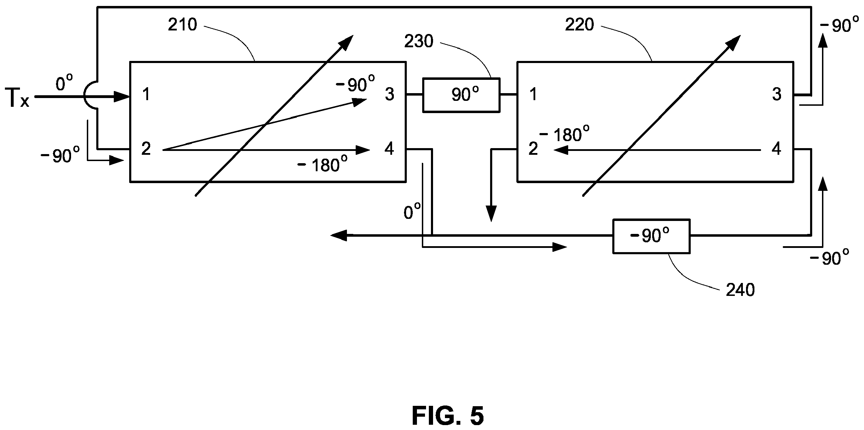

The Tx signal received by port (1) of coupler 220 is likewise split and the portion received at port (4) of coupler 220 is again not phase shifted. The portion of the Tx signal directed to port (3) of coupler 220 is shifted by -90° and looped back to port (2) of coupler 210 which is isolated from port (1). Still another portion of the Tx signal received by port (1) of coupler 220 is directed to port (2) as discussed with reference to FIG. 5.

FIG. 5 illustrates a continuation from the flows illustrated in FIG. 4. The portion of the Tx signal received at port (2) of coupler 210 from port (3) of coupler 220 is split, with the part directed to port (3) of coupler 210 not being phase shifted and therefore received at port (3) still shifted by -90°, the same as the portion of the Tx signal from port (1) of coupler 210 that is received at port (3) thereof (see FIG. 4). These two signals add constructively.

The portion of the Tx signal received at port (2) of coupler 210 that is directed to port (4) is phase shifted by an additional -90° and therefore received at port (4) shifted by -180°, completely out of phase with the portion of the Tx signal received from port (1) of coupler 210 (see FIG. 4) and these signals add destructively. Because the portion of the Tx signal received at port (4) from port (1) that is not phase-shifted is stronger than the out-of-phase signal received from port (2), the residual Tx signal that continues towards the antenna 110 is completely in-phase with the original Tx signal received at port (1) of the coupler 210.

As noted above, the Tx signal from port (4) of coupler 210 travels both towards the antenna 110 and towards the phase shifter 240 and to the port (4) of coupler 220. That signal, shifted by -90° by phase shifter 240, is again shifted another -90° while traversing coupler 220 to arrive at port (2) of coupler 220, phase shifted by -180°. Port (2) of coupler 220 is the output port to the receiver amplifier 150.

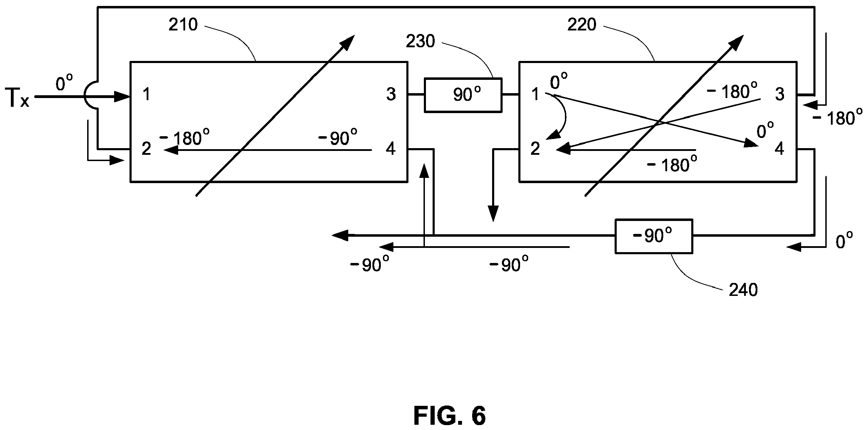

FIG. 6 illustrates a continuation from the flows illustrated in FIG. 5. A portion of the Tx signal received by coupler 220 at port (1) initially at 0° is directed without phase shift to port (4) of coupler 220, through a -90° phase shift by phase shifter 240, and to the node between antenna 110 and port (4) of coupler 210. Accordingly, two Tx signals are directed towards the antenna 110, a portion of this signal with the -90° phase shift, and the portion of the Tx signal first received at port (4) of coupler 210 without phase shift (see FIG. 4).

The balance of the -90° phase-shifted signal from port (4) of coupler 220 (i.e., that portion not received by antenna 110) is received at port (4) of coupler 210 and phase shifted by another -90° to emerge at port (2) of coupler 210 with a -180° phase shift. This signal propagates to port (3) of coupler 220, and without further phase shift to port (2) of coupler 220 to constructively add with the portion from port (4) of coupler 220 which is also -180° out of phase.

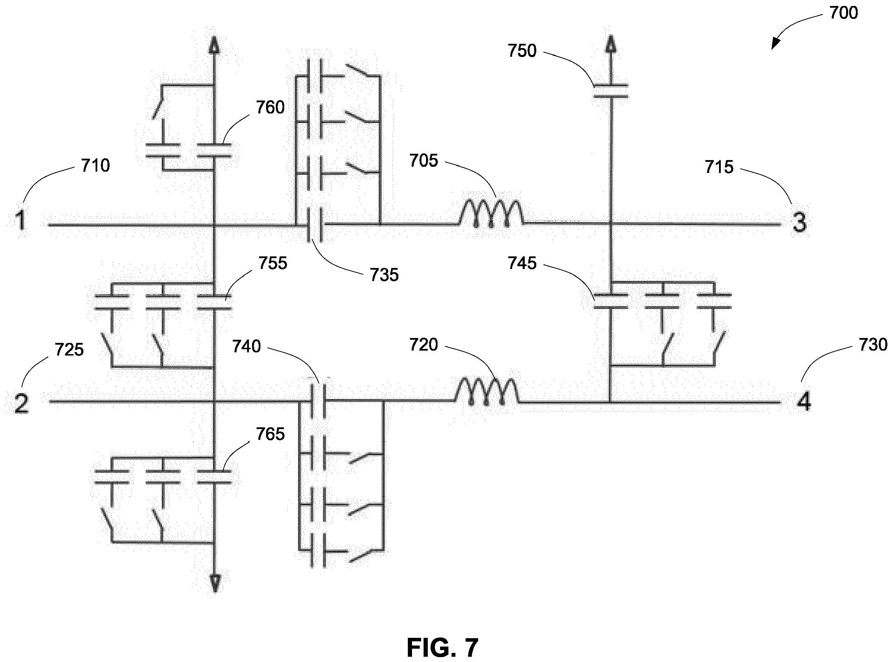

Lastly, an amount of power sufficient to cancel the combined -180° signal that has been received at port (2) of coupler 220 is directed from port (1) of coupler 220 with a 0° phase to port (2) of coupler 220. As discussed below with respect to FIG. 7, a capacitor can be used to tune coupler 220 to obtain the correct amount of power at 0° to cancel the combined signal at -180°. It should be noted that essentially the same process works for the Rx signal and therefore, for brevity, only the Tx signal is discussed herein.

FIG. 7 illustrates an exemplary circuit 700 for a coupler of the present invention. The circuit 700 has four numbered ports and a first inductor 705 coupled between a first port 710 and a third port 715, a second inductor 720 coupled between a second port 725, a fourth port 730, as well as a first capacitor 735 coupled between the first port 710 and the first inductor 705 and a second capacitor 740 coupled between the second port 725 and the second inductor 720, such that the first inductor 705 and first capacitor 735 are arranged in parallel with the second inductor 720 and second capacitor 740.

In various embodiments the circuit 700 also can also comprise one or more of a third capacitor 745 coupled between the third port 715 and the fourth port 730, a fourth capacitor 750 coupled between the third port 715 and ground, a fifth capacitor 755 coupled between the first port 710 and the second port 725, a sixth capacitor 760 coupled between the first port 710 and ground, and a seventh capacitor 765 coupled between the second port 725 and ground. In various embodiments, any of the aforementioned capacitors can be tunable so as to have a selectable capacitance. For example, a number of capacitors can be switchably coupled in parallel, as shown, to allow any of a number of fixed capacitances to be selected based on the capacitances of the capacitors selected to be coupled in parallel. Switchable capacitors are typically operated in pairs such that capacitors 745 and 755, for example, switch affect the degree of isolation between ports (1) and (2). Control logic (not shown) is used to modify switch setting to change frequency bands.

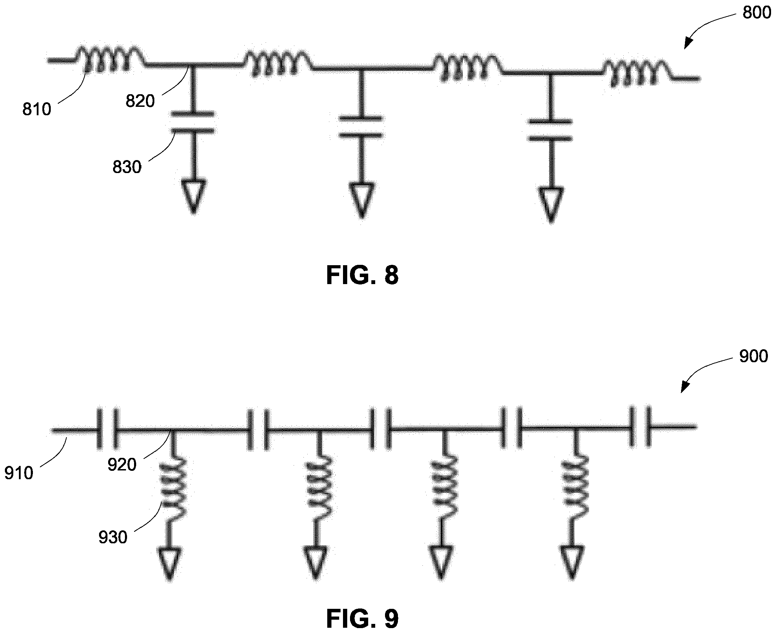

FIGs. 8 and 9 illustrate two exemplary circuits 800 and 900, respectively, that can provide the functionality of the phase shifters 240, 230, respectively. The circuit 800 includes a number of inductors 810 in series, with a node 820 between adjacent inductors 810, each node 820 coupled to ground by a capacitor 830. The circuit 800 serves to induce a phase shift of -90°. In the particular example of FIG. 8 there are four inductors 810 with three nodes 820 therebetween, and three capacitors 830 coupled to ground, but other numbers of inductors 820 is not limited to this embodiment. The circuit 900 includes a number of capacitors 910 in series, with a node 920 between adjacent capacitors 910, each node 920 coupled to ground by an inductor 930. The circuit 900 serves to induce a phase shift of 90°. In the particular example of FIG. 9 there are five capacitors 910 with four nodes 920 therebetween, and four inductors 930 coupled to ground, but other numbers of capacitors 920 is not limited to this embodiment.

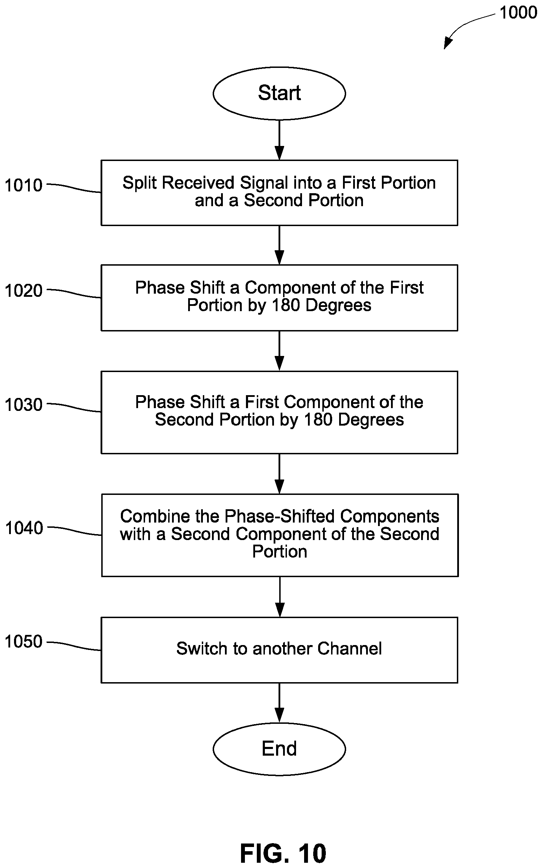

FIG. 10 illustrates an exemplary method 1000 of the present invention. This method can be used for operating a duplexer to cancel a transmission signal at a receiver, for example. The method 1000 comprises a step 1010 of splitting a signal into a first portion and a second portion, a step 1020 of phase shifting a component of the first portion of the signal by 18°, a step 1030 of phase shifting a component of the second portion of the signal by 180°, and a step 1040 of combining the phase-shifted components with a second component of the second portion of the signal.

The step 1010 of splitting the signal into a first portion and a second portion can be performed by introducing the signal initially into a port of a first coupler. The step 1020 can comprise obtaining a first part of the initial signal and phase shifting it twice, both times by 90°, to obtain a 180° phase shift. This can be performed, for example, by obtaining the first part of the initial signal from another port of the first coupler, where the output of that port is not phase shifted, and then phase shifting that part of the initial signal by 90° with a phase shifter, for instance, and then phase shifting that part of the initial signal by another 90° by passing the signal through a second coupler.

The step 1030 can comprise obtaining a second part of the initial signal and phase shifting it twice, both times by 90°, to obtain a 180° phase shift. This can be performed, for example, by obtaining the second part of the initial signal from a port of the second coupler, where the output of that port is not phase shifted, and then phase shifting that part of the initial signal by 90° with a phase shifter, then phase shifting that part of the initial signal by another 90° by passing the signal through the first coupler. In some of these embodiments the second coupler receives the second part of the initial signal from the first coupler via another phase shifter. It is noted that the direction of the 180° phase shifts in steps 1020 and 1030 can be either +180° or -180°, and need not both be the same.

The step 1040 of combining the phase-shifted components with a second component of the second portion of the signal can comprise obtaining the second component of the second portion from the initial port of the first coupler. This can be achieved by passing part of the initial signal through the first coupler, inducing a phase shift therein, and then passing the phase-shifted signal through a phase shifter to restore the initial phase of the signal.

In an optional step 1050 of the method 1000 the duplexer can be switched from operating in a first channel to operating in a second channel. Step 1050 can be achieved, for instance, by controlling switch settings within the duplexer. In various embodiments, the switches can vary electrical properties such as capacitance, resistance, and/or inductance at points within the duplexer to configure the duplexer to the different operating channels. For instance, switching logic can receive a command to employ a new channel and can switch the duplexer to the new channel by changing switch settings of switchable capacitors in order to reconfigure the duplexer to operate at the frequency of the new channel.

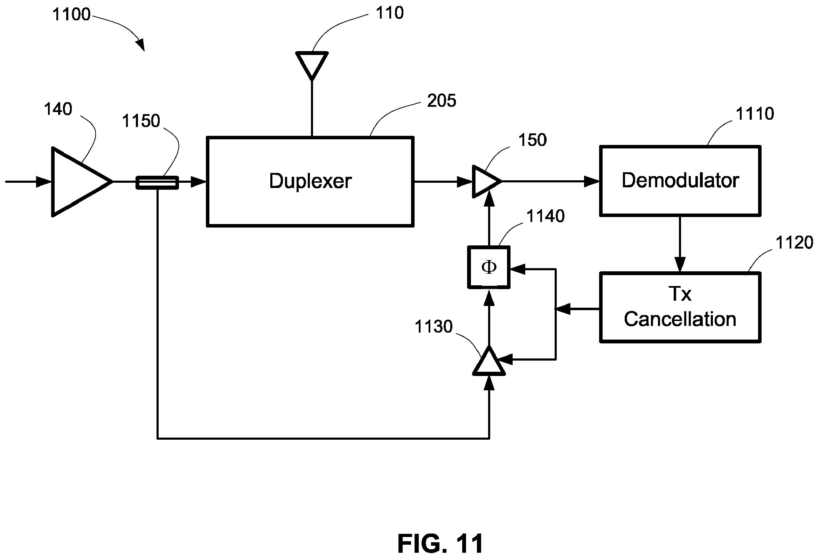

FIG. 11 illustrates an exemplary circuit 1100 of the present invention comprising a power amplifier 140 and receiver amplifier 150 joined together by a duplexer 205. The circuit 1100 can connect to an antenna 110 at the duplexer 205, and in some embodiments the circuit 1100 includes the antenna 110. In circuits 1100, while the duplexer 205 is effective to substantially cancel the Tx signal at the receiver amplifier 150, however, some leakage of the Tx signal can still persist. A feedback loop in the circuit 1100 is therefore employed to cancel that remaining Tx signal at the receiver amplifier 150.

The feedback loop includes a demodulator 1110 that receives the amplified output from the receiver amplifier 150. The demodulator 1110 separates the Rx signal from any residual Tx signal within the amplified output. The separation can be performed by filtering, for example, by digital filtering in the base band. The demodulator 1110 demodulates the Rx signal and sends the demodulated Rx signal to an output such as a speaker of an ear piece. The demodulator 1110 also measures the amplitude of the residual Tx signal and provides that measurement to a Tx cancellation circuit 1120.

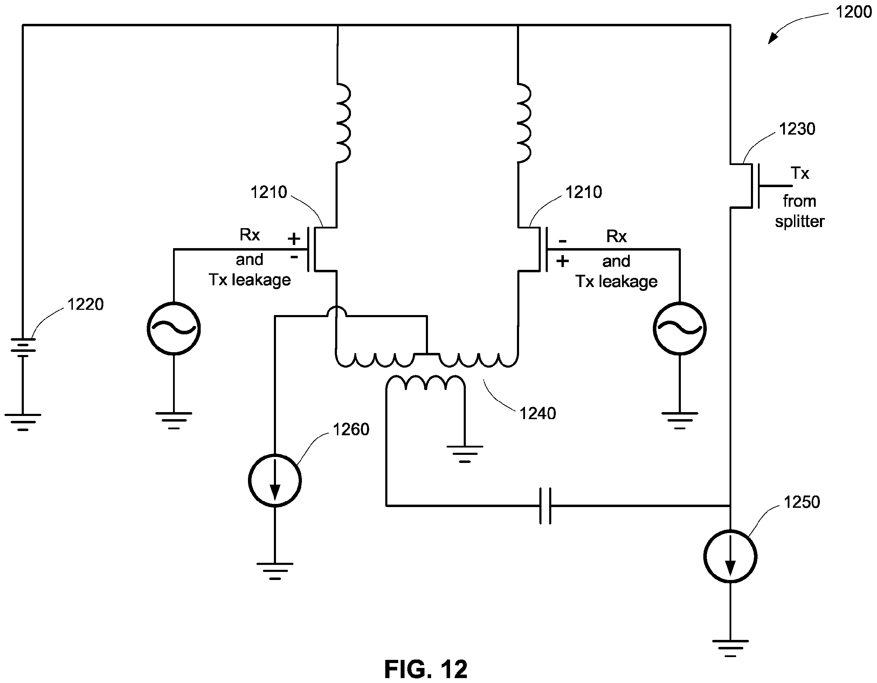

The Tx cancellation circuit 1120, in turn, receives the measured amplitude of the residual Tx signal and responsively controls both of a gain control circuit 1130 and a phase control circuit 1140 arranged in series. A directional coupler 1150 disposed between the power amplifier 140 and the duplexer 205 directs a small portion of the amplified RF signal from the output of the power amplifier 140 and to the gain control circuit 1130. The gain control circuit 1130 adjusts the amplitude of the RF signal from the coupler 1150 to match the amplitude of the residual Tx signal. This amplitude adjusted RF signal is next phase shifted by the phase control circuit 1140 to the same phase as the residual Tx signal. Then the amplitude and phase shifted RF signal is applied to the source of the receiver amplifier 150 to cancel the Tx signal at the gate, as shown in FIG. 12. It will be appreciated that the order of the circuits 1130 and 1140 can be reversed, in other embodiments. In various embodiments some or all of the Tx cancellation circuit 1120, the gain control circuit 1130, and the phase control circuit 1140 can be components of, or integrated with, the receiver amplifier 150.

A suitable gain control circuit 1130 can be, for example, an RF digital step attenuator. A suitable phase control circuit 1140 can be, for example, an RF digital phase shifter. Each of these are stepwise adjustable, based on digital words from the Tx cancellation circuit 1120. For instance, the gain control circuit 1130 can vary attenuation by steps of 0.25 dB, 0.5 dB, or 1 dB, in various embodiments. Likewise, an 8-bit full-range phase shifter, in some embodiments, can vary the signal within a phase range of 358.6° by increments of 180°, 90°, 45°, 22.5°, 11.2°, 5.6°, 2.8° and 1.4° bits.

The Tx cancelation circuit 1120 includes, in some embodiments, a digital implementation of an algorithm to find a minimum. In these embodiments, the demodulator 1110 provides the measured amplitude of the residual Tx signal in a digital format to the Tx cancellation circuit 1120 and the Tx cancellation circuit 1120 further includes digital to analog converters to control the gain control circuit 1130 and the phase control circuit 1140. In these embodiments, a suitable algorithm is compiled directly into digital CMOS circuits using place and route tools. It will be understood that the Tx cancellation circuit 1120 can be implemented in either the base band or as part of the receiver amplifier 150, and FIG. 11 is meant to represent both.

In operation, the feedback loop converges to a state in which the residual Tx signal has essentially no amplitude and the Tx cancellation circuit 1120 holds the gain control circuit 1130 and phase control circuit 1140 steady, adjusting the gain and phase only in response to an increase in the measured residual Tx signal in order to suppress it again.

One exemplary algorithm the Tx cancellation circuit 1120 can employ to achieve the required control of gain and phase is to first vary one of the gain or phase by a step in one direction, monitor the change in the residual Tx signal, and continue in that direction another step if the first step produced a decrease in the residual Tx signal, and control it a step in the opposite direction otherwise. Continue varying gain and phase until a minimum has been identified. Gain and phase can be varied alternatingly, by finding a first minimum by varying phase followed by finding a second minimum by varying gain, and repeating, or gain and phase can be varied simultaneously. In further embodiments, in addition to measuring just amplitude of the residual Tx signal, the phase of the residual Tx signal can also be measured and provided to the Tx cancellation circuit 1120 to be used to achieve control through a more efficient algorithm.

FIG. 12 is a low noise amplifier 1200 according to an exemplary embodiment of the present invention, suitable as the receiver amplifier 150. Some components have been omitted from the amplifier 1200 for clarity. The amplifier 1200 in this instance is a differential amplifier and includes a pair of transistors 1210, such as CMOS transistors. Half of the output from the duplexer 205 is applied to each gate of the two transistors 1210, where the output includes the Rx signal received from the antenna 110 plus some leakage of the differential Tx signal. A power supply 1220 provides a DC voltage to the drains of the transistors 1210. The amplifier 1200 also includes a transistor 1230 that receives the same DC voltage from power supply 1220 at its drain.

Transistor 1230 receives at its gate the gain adjusted and phase shifter Tx signal from the phase control circuit 1140 and applies that same signal to the sources of the transistors 1210 through a balun 1240. The point where the gain and phase adjusted signal is applied to the balun 1240 is a very low impedance point. A current source 1250, together with transistor 1230, comprise a source follower. The output impedance of this source follower is very low (ideally a voltage source) and used to maintain the signal level when cascading different structures. Current source 1250 has a theoretical infinite output impedance and maintains the output current no matter the voltage developed. Accordingly, the output voltage is less sensitive to the impedance shown by the sources of the transistors 1210 through the balun 1240. The balun 1240 applies an RF signal to the transistors 1210 over the bias applied by a second current source 1260. The amplified signal is taken from the drains of the transistors 1210. In various embodiments these drains are loaded by inductors or resistors.

In the foregoing specification, the invention is described with reference to specific embodiments thereof, but those skilled in the art will recognize that the invention is not limited thereto. Various features and aspects of the above-described invention may be used individually or jointly. Further, the invention can be utilized in any number of environments and applications beyond those described herein without departing from the broader spirit and scope of the specification. The specification and drawings are, accordingly, to be regarded as illustrative rather than restrictive. It will be recognized that the terms "comprising," "including," and "having," as used herein, are specifically intended to be read as open-ended terms of art. The term "connect" is differentiated herein from the term "couple" such that when two components are "connected" there are no other components disposed between them, whereas when two components are "coupled" there may be other components disposed between them. The use of the term "means" within a claim of this application is intended to invoke 35 U.S.C. 112(f) only as to the limitation to which the term attaches and not to the whole claim, while the absence of the term "means" from any claim should be understood as excluding that claim from being interpreted under 112(f). As used in the claims of this application, "configured to" and "configured for" are not intended to invoke 35 U.S.C. 112(f).

## Claims

1. A circuit comprising:
a power amplifier having an input for receiving an input signal and having an output for a transmission signal that is the input signal amplified;
a receiver amplifier having an output for an amplified receiver signal;
a duplexer configured to connect to an antenna and to connected to the power amplifier to receive the transmission signal therefrom, and connected to the receiver amplifier, the duplexer providing an antenna signal from the antenna to an input of the receiver amplifier;
a directional coupler disposed between the power amplifier and the duplexer and configured to pass a majority of the transmission signal to the duplexer and further configured to direct a balance of the transmission signal to a feedback loop;
the feedback loop being configured to adjust a gain and a phase of the balance of the transmission signal to produce a phase and gain adjusted signal, the feedback loop being further configured to apply the phase and gain adjusted signal to the receiver amplifier.

2. The circuit of claim 1 wherein the feedback loop includes a gain control circuit and a phase control circuit arranged in series, wherein one of the gain and phase control circuits receives the balance of the transmission signal and the other of the gain and phase control circuits applies the phase and gain adjusted signal to the receiver amplifier.

3. The circuit of claim 2 wherein the feedback loop further includes a Tx cancellation circuit configured to control the gain and phase control circuits based on the amplified receiver signal.

4. The circuit of claim 2 or 3 wherein the other of the gain and phase control circuits applies the phase and gain adjusted signal to a source of the receiver amplifier.

5. The circuit of one of the preceding claims wherein the receiver amplifier is a differential amplifier including a pair of transistors.

6. The circuit of claim 5 wherein the receiver amplifier includes a balun bridging the sources of the pair of transistors and the phase and gain adjusted signal is applied to the receiver amplifier through the balun.

7. The circuit of one of the preceding claims wherein the duplexer comprises
a first coupler having four ports,
a second coupler identical to the first coupler,
a first phase shifter coupled between a first port of the first coupler and a first port of the second coupler, and
a second phase shifter coupled between a second port of the first coupler and another port of the second coupler.

8. The circuit of one of the preceding claims further comprising the antenna coupled to the duplexer.

9. A method for cancelling a leaked transmission signal at a receiver amplifier, the method comprising:
transmitting by
amplifying a first signal to produce a first amplified signal,
splitting the first amplified signal into a first portion comprising a majority of the first amplified signal and a second portion comprising a balance of the first amplified signal, and
transmitting the first portion to a duplexer coupled to an antenna, wherein a segment of the first portion becomes the leaked transmission signal; and
receiving while transmitting by
receiving from the antenna, through the duplexer, at the receiver amplifier a second signal,
receiving through the duplexer at the receiver amplifier the leaked transmission signal, and
applying the second portion of the first amplified signal to the receiver amplifier to cancel the leaked transmission signal.

10. The method of claim 9 wherein applying the second portion of the first amplified signal to the receiver amplifier includes applying the second portion to a source of the receiver amplifier.

11. The method of claim 9 or 10 wherein applying the second portion of the first amplified signal to the receiver amplifier includes adjusting a gain and a phase of the second portion.

12. The method of claim 11 wherein adjusting the gain and phase of the second portion includes monitoring an amplified output of the receiver amplifier.
